# EUROPEAN PATENT APPLICATION

(11) **EP 4 576 158 A1**
(43) Date of publication of application: **25.06.2025**
(21) Application number: 23217732.9
(22) Date of filing: 18.12.2023
(51) Int. Cl.: H01J 37/28, H01J 37/153

(54) **CHARGED PARTICLE-OPTICAL MODULE, CHARGED PARTICLE-OPTICAL DEVICE, AND A METHOD OF USING A CHARGED-PARTICLE APPARATUS**

(71) Applicant: ASML Netherlands B.V., 5500 AH Veldhoven (NL)
(72) Inventor: MANGNUS, Albertus, Victor, Gerardus, 5500 AH Veldhoven (NL)
(74) Representative: ASML Netherlands B.V.

(57) **Abstract**

A charged particle-optical module for generating a plurality of sub-beams 211-213 from a source beam 202 of electrons, the module for use in an charged particle-optical device for projecting a plurality of sub-beams 211-213 toward a sample. The charged particle module comprises: an electron source 201 comprising an emitter 63 configured to emit a source beam 202 along a divergent path; a beam limiter 236 defining an array of apertures 232 and positioned in the divergent path to form a grid of sub-beams from the source beam; a condenser lens array 231 configured to operate on the sub-beams; and a macro-corrector system 60 configured to act on the sub-beams. The macro-corrector system is at least partly comprised between the beam limiter and the condenser lens array.

## Description

### FIELD

The embodiments provided herein generally relate to a charged particle-optical module, a charged particle-optical device, and a method of using a charged-particle apparatus.

### BACKGROUND

When manufacturing semiconductor integrated circuit (IC) chips, undesired pattern defects often occur on a substrate (i.e. wafer) or a mask during the fabrication processes, thereby reducing the yield. Such defects can occur as a consequence of, for example, optical effects and incidental particles as well as in subsequent processing steps such as etching, deposition or chemical mechanical polishing. Monitoring the extent of the undesired pattern defects is therefore an important process in the manufacture of IC chips. More generally, the assessment (such as assessment, review and/or measurement) of a surface of a substrate, or other object/material, is an important process during and/or after its manufacture.

Pattern assessment systems with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted at a sample for example with a final deceleration step in order to land on a sample at a relatively low landing energy. The beam of electrons is focused as a probing spot on the sample. The interactions between the material structure at the probing spot and the landing electrons from the primary beam of electrons cause charged particles such as electrons to be emitted from the surface. Such charged particles may be referred to as signal particles such as secondary electrons, backscattered electrons or Auger electrons. The generated secondary electrons may be emitted from the material structure of the sample. By scanning the primary beam as the probing spot over the sample surface, interaction products may be emitted from the surface of the sample such as electromagnetic radiation and the signal particles which, as mentioned, may comprise secondary electrons, backscatter electrons or both. By collecting these interaction products such as secondary electrons from the sample surface, for detection an assessment system such as pattern assessment tool may obtain an image representing characteristics of the material structure of the surface of the sample.

There is a general need to improve characteristics of a charged-particle apparatus. In particular, it is desirable to control various characteristics of the beam of charged particles without incurring unwanted beam current loss through sub-beam interactions with plates of a lens array. The process of operating on the beam of charged particles to control various characteristics may be improved for example without incurring such current loss.

### SUMMARY

The embodiments provided herein disclose a charged particle-optical module, a charged particle-optical device, and a method of using a charged-particle apparatus, that seeks to improve control of beam characteristics with incurring beam current loss.

According to a first aspect of the invention, there is provided a charged particle-optical module for generating a plurality of sub-beams from a source beam of electrons. The module is suitable for use in an charged particle-optical device for projecting a plurality of sub-beams toward a sample. The charged particle module comprises an electron source, a beam limiter, a condenser lens array, and a macro-corrector system. The electron source comprises an emitter configured to emit a source beam along a divergent path. The beam limiter defines an array of apertures. The beam limiter is positioned in the divergent path. The array of apertures are configured to form a grid of sub-beams from the source beam along the divergent path. The condenser lens array is configured to operate on the sub-beams. The condenser lens array comprises at least two plates in which are each defined an array of apertures corresponding to the sub-beams and which are configured to operate on the sub-beams. The macro-corrector system is configured to act on the sub-beams. The macro-corrector system is at least partly comprised between the beam limiter and the condenser lens array.

According to a second aspect of the invention, there is provided a charged particle-optical device for projecting a plurality of sub-beams of charged particles towards a sample. The charged particle-optical apparatus comprises the charged particle-optical module.

According to a third aspect of the invention, there is provided a method of using a charged-particle apparatus to generate a plurality of sub-beams from a source beam of charged particles and direct the sub-beams downbeam toward a sample position. The method comprises: emitting a source beam of charged particles along a divergent path; forming a grid of sub-beams from the source beam at an array of apertures defined in a beam limiter; operating on the sub-beams using a condenser lens array, the condenser lens array comprising at least two plates in which are each defined an array of apertures corresponding to the sub-beams and which operate on the beam; and acting on the sub-beams using a macro-corrector system, at least part of the macro-corrector system being between the beam limiter and the condenser lens array.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam assessment apparatus.
**FIG. 2** is a schematic diagram illustrating an exemplary multi-beam apparatus that is part of the exemplary charged particle beam assessment apparatus of **FIG. 1****.**
**FIG. 3** is schematic diagram of exemplary multi-beam apparatus illustrating an exemplary configuration of source conversion unit of the exemplary charged particle beam assessment apparatus of **FIG. 1****.**
**FIG. 4** is a schematic diagram of exemplary multi-beam apparatus.
**FIG. 5** is a schematic cross-sectional view of an objective lens of an assessment apparatus.
**FIG. 6** is a bottom view of the objective lens of **FIG. 5****.**
**FIG. 7** is a schematic diagram of an exemplary charged-particle apparatus according to an embodiment.
**FIG. 8** is a schematic diagram of an exemplary charged-particle apparatus according to an embodiment.
**FIG. 9** is a schematic diagram of an exemplary charged-particle apparatus according to an embodiment.
**FIG. 10A-D** are schematic diagrams, each illustrating a grid of sub-beams incident on a plate of a condenser lens array.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one defect can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by assessment systems (such as a Scanning Electron Microscope ('SEM')) is essential for maintaining high yield and low cost.

A SEM comprises an scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system (or electron optical apparatus). The primary electrons interact with the sample and generate signal particles such as secondary electrons and backscatter electrons. The detection apparatus captures the electrons emitted from the sample as the sample is scanned so that the SEM can create an image of the scanned area of the sample. For high throughput assessment, some of the assessment apparatuses use multiple focused beams, i.e. a multi-beam, of primary electrons. The component beams of the multi-beam such as a grid of beams (or a beam grid) may be referred to as sub-beams or beamlets, besides beams. The beams of the multi-beam can scan different parts of a sample simultaneously. A multi-beam assessment apparatus can therefore inspect a sample at a much higher speed than a single-beam assessment apparatus.

An implementation of a known multi-beam assessment apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus (or electron apparatus), it is appreciated that the embodiments are not used to limit the present disclosure to specific charged particles. References to electrons throughout the present document may therefore be more generally be considered to be references to charged particles, with the charged particles not necessarily being electrons.

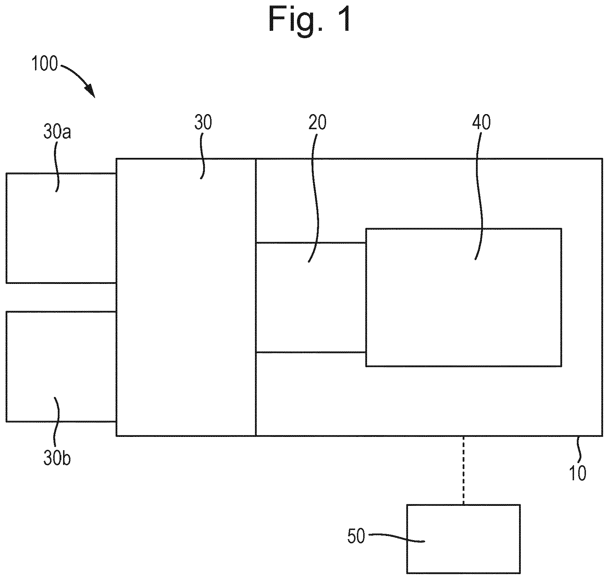

Reference is now made to **FIG. 1****,** which is a schematic diagram illustrating an exemplary charged particle beam assessment apparatus 100. The charged particle beam apparatus 100 (for example a charged particle beam apparatus 100) of **FIG. 1** includes a main chamber 10, a load lock chamber 20, an electron beam tool or apparatus 40, an equipment front end module (EFEM) 30 and a controller 50. The electron beam apparatus 40 is located within main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical device 41.

The controller 50 is electronically connected to electron beam tool or apparatus 40. The controller 50 may be a processor (such as a computer) configured to control the charged particle beam apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the components (or even one more of the elements of a component (i.e. component element)) of the charged particle beam apparatus. The controller may be distributed over at least two of the components or even elements for example of the same or different components. While the present disclosure provides examples of the main chamber 10 housing an electron beam apparatus, it should be noted that aspects of the disclosure in their broadest sense are not limited to a chamber housing an electron beam apparatus. Rather, it is appreciated that the foregoing principles may also be applied to other tools and other arrangements of apparatus, that operate under the second pressure.

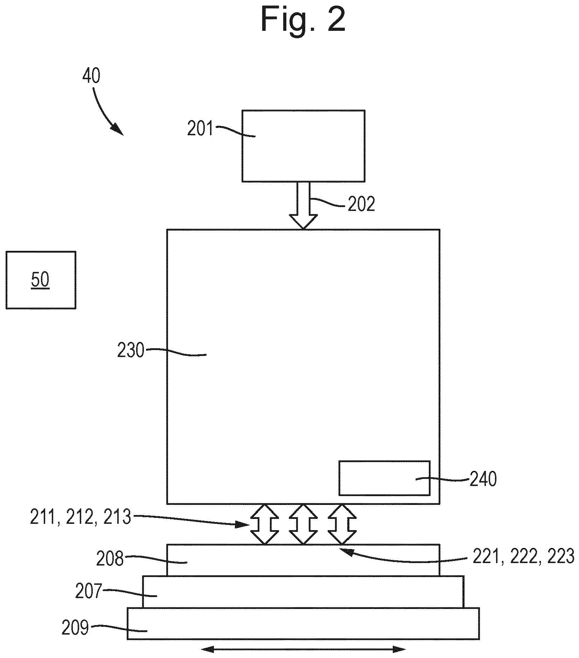

Reference is now made to **FIG. 2****,** which is a schematic diagram illustrating an exemplary electron beam apparatus 40 including a multi-beam apparatus which may be a multi-beam assessment apparatus that is part of the exemplary charged particle beam apparatus 100 of **FIG. 1****.** The multi-beam electron beam tool 40 (also referred to herein as apparatus 40) comprises a projection apparatus 230 (or an electron-optical device 41), an electron source 201, a motorized stage 209, and a sample holder 207. The electron-optical device 41 optionally comprises the electron source 201. The electron source 201 and the projection apparatus 230 may together be referred to as an illumination apparatus. The sample holder 207 is supported by the motorized stage 209 so as to hold a sample 208 (e.g., a substrate or a mask) for assessment. The multi-beam electron beam apparatus 40 further comprises an electron detection device 240.

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a source beam (or primary electron beam) 202.

The projection apparatus 230 is configured to convert the source beam 202 into a plurality of sub-beams 211, 212, 213 and to direct each sub-beam onto the sample 208. Although three sub-beams are illustrated for simplicity, there may be many tens, many hundreds or many thousands of sub-beams.

The controller 50 may be connected to various parts of the charged particle beam apparatus 100 of **FIG. 1****,** such as the electron source 201, the electron detection device 240, the projection apparatus 230, and the motorized stage 209. The controller 50 may perform various image and signal processing functions. The controller 50 may also generate various control signals to govern operations of the charged particle beam apparatus, including the charged particle multi-beam apparatus.

The projection apparatus 230 may be configured to focus the sub-beams 211, 212, and 213 onto a sample 208 for assessment, for example assessment, and may form three probe spots 221, 222, and 223 on the surface of the sample 208. The projection apparatus 230 may be configured to deflect the primary sub-beams 211, 212, and 213 to scan the probe spots 221, 222, and 223 across individual scanning areas in a section of the surface of sample 208. In response to incidence of the primary sub-beams 211, 212, and 213 on the probe spots 221, 222, and 223 on the sample 208, signal particles such as electrons are generated from the sample 208 which include secondary electrons and backscattered electrons. The secondary electrons typically have electron energy ≤ 50 eV and backscattered electrons typically have electron energy between 50 eV and the landing energy of the primary sub-beams 211, 212, and 213.

The electron detection device 240 is configured to detect secondary electrons and/or backscattered electrons and to generate corresponding signals which are sent to the controller 50 or a signal processing system (not shown), e.g. to construct images of the corresponding scanned areas of the sample 208. The electron detection device may be incorporated into the projection apparatus. Alternatively it may be separate therefrom, with a secondary electron-optical column (or device) being provided to direct secondary electrons and/or backscattered electrons to the electron detection device.

The controller 50 may comprise an image processing system that includes an image acquirer (not shown) and a storage device (not shown). For example, the controller may comprise a processor, a computer, a server, a mainframe host, terminals, a personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof.

The image acquirer may acquire one or more data sets representative of respective images of a sample based on a detection signal (which may be considered to be an imaging signal) received from the electron detection device 240. Reference to an image hereinafter may refer to a corresponding data set. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of the sample 208. The acquired images may comprise multiple images of a single imaging area of the sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of the primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the motorized stage 209 to move the sample 208 during assessment of the sample 208. The controller 50 may enable the motorized stage 209 to move the sample 208 in a direction, preferably continuously, for example at a constant speed, at least during sample assessment. In an different arrangement the motorized stage may move the sample continuously between sequential steps so that the different beams of the beam grid scan a respective scan area, so that the beam grid scans a region of a sample surface, such as described with reference to WO 2022128392 A1 which is incorporated so far as the disclosure of scanning strategies. The controller 50 may control movement of the motorized stage 209 so that it changes the speed of the movement of the sample 208 dependent on various parameters. For example, the controller may control the stage speed (including its direction) depending on the characteristics of the assessment steps of scanning process.

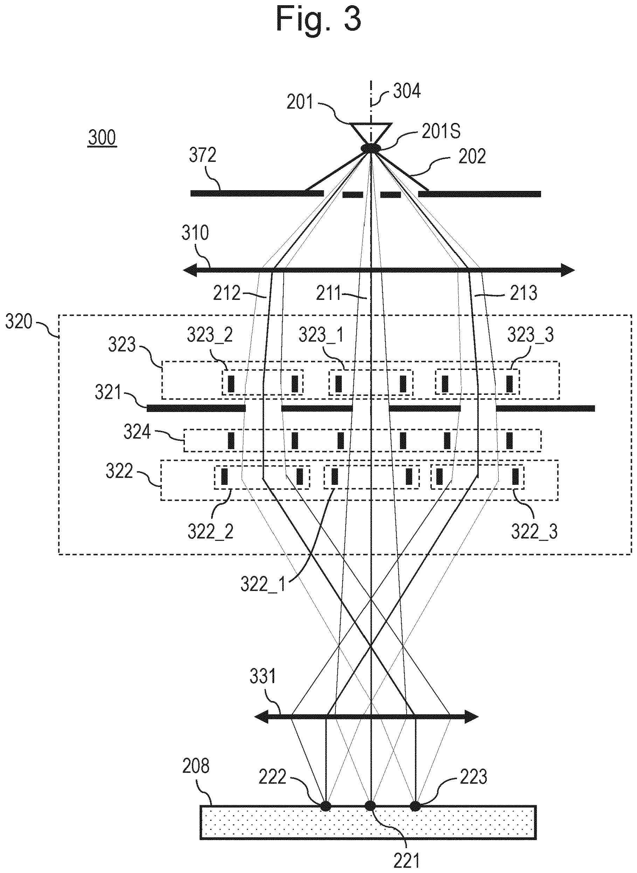

Reference is now made to **FIG. 3****,** which is a schematic diagram of exemplary multi-beam apparatus illustrating an exemplary configuration of source conversion unit of the exemplary charged particle beam assessment apparatus of **FIG. 1****.** The apparatus 300 may comprise an electron source 201, a pre-sub-beam-forming aperture array 372 (or a beam shaping aperture array such as a bean limiting aperture array or a coulomb aperture array), a condenser lens 310, a source conversion unit 320, an objective lens 331, and a sample 208. The objective lens 331 may be configured to focus sub-beams 211, 212, and 213 onto a sample 208 for assessment and may form three probe spots 221, 222, and 223 on the surface of sample 208. The electron source 201, a pre-sub-beam-forming aperture array 372, a condenser lens 310 may be the components of an illumination apparatus comprised by the apparatus 300. The source conversion unit 320, an objective lens 331 may be the components of a projection apparatus comprised by the apparatus 300. Source conversion unit 320 may comprise an image-forming element array 322, an aberration compensator array 324, a beam-limit aperture array 321, and a pre-bending micro-deflector array 323. The pre-bending micro-deflector array 323 may deflect a plurality of primary sub-beams 211, 212, 213 of source electron beam 202 to normally enter the beam-limit aperture array 321, and pass through other components of the source conversion unit 320 such as the image-forming element array 322, and an aberration compensator array 324. The components of the source conversion unit 320 such as the electron source 201, the pre-sub-beam-forming aperture array 372, the condenser lens 310, the source conversion unit 320, and the objective lens 331 are aligned with a path of the beam grid and/or the electron-optical axis 304 of the apparatus. The electron source 201 generates a source-electron beam 202 generally along the electron-optical axis 304 and with a source crossover (virtual or real) 201S. The pre-sub-beam-forming aperture array 372 cuts the peripheral electrons of source electron beam 202 (or shapes the source beam to remove peripheral and/or excess electrons of source electron beam 202) to reduce a consequential Coulomb effect. The Coulomb effect is a source of aberration to the sub-beams due to interaction (e.g. repulsion) between electrons in different sub-beam paths. Source electron beam 202 may be shaped (e.g. trimmed) into a number of sub-beams, such as three sub-beams 211, 212 and 213, by pre-sub-beam-forming aperture array 372. The primary sub-beams 211, 212 and 213 are thus generated or divided out from the source beam electron beam 202 by interaction of the source electron beam 202 with the pre-sub-beam-forming aperture array. The pre-sub-beam-forming aperture array 372 may be considered to be a beam limiter. Although three sub-beams and their paths are referred to in the previous and following description, it should be understood that the description is intended to apply an apparatus, tool, or system with any number of sub-beams.

The source conversion unit 320 may include a beamlet-limit aperture array 321 with beam-limit apertures configured to shape the sub-beams 211, 212, and 213 generated by the pre-sub-beam-forming aperture array 372 from the source electron beam 202, or otherwise limit the existing sub-beams 211, 212, and 213 to generate additional sub-beams to provide the primary electron sub-beams directed towards the sample. The source conversion unit 320 may have an image-forming element array 322 with image-forming micro-deflectors, 322_1, 322_2, and 322_3. There is a respective micro-deflector associated with the path of each sub-beam. The micro-deflectors 322_1, 322_2, and 322_3 are configured to deflect the paths of the sub-beams 211, 212, and 213 towards the electron-optical axis 304. The micro-deflectors may comprise a plurality of deflector electrodes around an aperture for passage of a respective sub-beam. The deflected sub-beams 211, 212 and 213 form virtual images of source crossover 201S. The virtual images are projected onto the sample 208 by the objective lens 331 and form probe spots thereon, which are the three probe spots, 221, 222, and 223. Each probe spot corresponds to the location of incidence of a sub-beam path on the sample surface. The source conversion unit 320 may further comprise an aberration compensator array 324 configured to compensate aberrations of each of the sub-beams. The aberrations in each sub-beam are typically present on the probe spots, 221, 222, and 223 that would be formed a sample surface. The aberration compensator array 324 may include a field curvature compensator array (not shown) with micro-lenses. The field curvature compensator and micro-lenses are configured to compensate the sub-beams for field curvature aberrations evident in the probe spots, 221, 222, and 223. The aberration compensator array 324 may include an astigmatism compensator array (not shown) with micro-stigmators. The micro-stigmators are controlled to operate on the sub-beams to compensate astigmatism aberrations that are otherwise present in the probe spots, 221, 222, and 223. The micro-stigmators may comprise a plurality of deflector electrodes around an aperture for passage of a respective sub-beam.

The source conversion unit 320 may further comprise a pre-bending micro-deflector array 323 with pre-bending micro-deflectors 323_1, 323_2, and 323_3 to bend the sub-beams 211, 212, and 213 respectively. The pre-bending micro-deflectors 323_1, 323_2, and 323_3 may bend the path of the sub-beams onto the beamlet-limit aperture array 321. The sub-beam path of the incident on beamlet-limit aperture array 321 may be orthogonal to the plane of orientation of the beamlet-limit aperture array 321. The condenser lens 310 may direct the path of the sub-beams onto the beamlet-limit aperture array 321. The condenser lens 310 may operate magnetically. The condenser lens 310 may focus the three sub-beams 211, 212, and 213 to become parallel beams along electron-optical axis 304, so that it is substantially perpendicularly incident onto source conversion unit 320, which may correspond to the beamlet-limit aperture array 321.

The image-forming element array 322, the aberration compensator array 324, and the pre-bending micro-deflector array 323 may comprise multiple layers of sub-beam manipulating devices, some of which may be in the form or arrays, for example: micro-deflectors, micro-lenses, or micro-stigmators.

In source the conversion unit 320, the sub-beams 211, 212 and 213 of the source electron beam 202 are respectively deflected by the micro-deflectors 322_1, 322_2 and 322_3 of image-forming element array 322 towards the electron-optical axis 304. It should be understood that the sub-beam 211 path may already correspond to the electron-optical axis 304 prior to reaching micro-deflector 322_1, accordingly the sub-beam 211 path may not be deflected by micro-deflector 322_1.

The objective lens 331 focuses the sub-beams onto the surface of the sample 208, i.e., it projects the three virtual images onto the sample surface. The three images formed by three sub-beams 211 to 213 on the sample surface form three probe spots 221, 222 and 223 thereon. The three deflected sub-beams consequently pass through or approach a focal point of objective lens 331 that is upbeam of the objective lens (and may be referred to as a back focal point of the objective lens 331).

At least some of the above-described components in FIG. 3 may individually, or in combination with each other, be referred to as a manipulator array, or manipulator, because they operate one or more beams, or sub-beams, of charged particles.

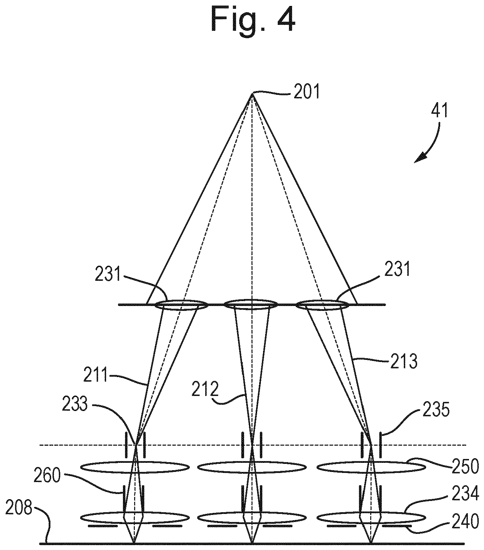

**FIG.** 4 is a schematic diagram of a part of an electron beam apparatus for example an assessment tool comprising an electron source 201 and an electron optical device 41 (or electron optical column). (In another arrangement the source is part of the electron-optical device). The electron optical device comprises a plurality of electron optical components. An electron optical component is any component that affects (e.g. directs, shapes or focuses) an electron beam and may use electric and/or magnetic fields. The electron source 201 directs electrons toward an array of condenser lenses 231 forming part of the electron optical device. The electron source is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array therefore functions as a beam limiter, a beam divider, beam splitter, or beam generator or beam shaper. The condenser lens array may take the form of at least two plates, acting as electrodes, with an aperture in each plate aligned with each other and corresponding to the location of a sub-beam. At least two of the plates are maintained during operation at different potentials to achieve the desired lensing effect. The plates therefore have an array of apertures, each aperture corresponding to the path of a sub-beam. Thus the condenser lens array may comprise at least two plates in which arrays of apertures may be defined. The plate positioned most up beam is an aperture array configured to function as the beam limiter in generating a plurality of beams and may referred to as a beam limiting aperture array or a beam limiter. In a different arrangement the beam limiter may be part of or associated with the condenser lens array, with a separate function from lensing the sub-beams. Between the plates of the condenser lens array, and indeed between other electrodes along the path of the charged particle beam, are electrically insulating plates for example made of an insulating material such as ceramic or glass, with one or more apertures for the sub-beams. The insulating plates may support the plates acting as electrodes. The insulating plates may be space apart the plates operating as electrodes. The insulating plate may be referred to as a planar spacer. In the insulating plate may be an aperture with a rim positioned sufficiently far from the paths of the sub-beams so that interaction between the surfaces of the rim and the sub-beams are minimized.

In an arrangement the condenser lens array is formed of three plate arrays in which charged particles have the same energy as they enter and leave each lens, which arrangement may be referred to as an Einzel lens. The beam energy is the same on entering as leaving the Einzel lens. Thus, dispersion only occurs within the Einzel lens itself (between entry and exit electrodes of the lens).

Each condenser lens in the array directs electrons into a respective sub-beam 211, 212, 213 which is focused at a respective intermediate focus 233. The sub-beams diverge with respect to each other. At the intermediate focuses 233 are collimators e.g. deflectors 235. The deflectors 235 are positioned in the sub-beam paths at, or at least around, the position of the corresponding intermediate focusses 233 or focus points (i.e. points of focus). Thus the deflectors are respectively positioned along a sub-beam path at the intermediate image plane of the associated sub-beam, i.e. at its focus or focus point. The deflectors 235 are configured to operate on the respective sub-beams 211, 212, 213. Deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or (collimating deflectors). So that the deflectors 235 in effect collimate the paths of the sub-beams, upbeam of the deflectors, the sub-beam paths with respect to each other diverge. Downbeam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. Other arrangements may be used as collimator such as a lens array, such as a collimator array of curved electrodes as disclosed in EPA23211553.5 filed on 22 November 2023 which is hereby incorporated by reference at least so far as the disclosure of curved electrodes.

Below (i.e. downbeam or further from the source 201) collimators (such as deflectors 235) there is a control lens array 250 comprising a control lens for each sub-beam 211, 21, 213. The control lens array 250 may comprise at least two, for example three, plate electrode arrays connected to respective potential sources. A function of the control lens array 250 is to optimize the beam opening angle with respect to the demagnification of the beam and/or to control the beam energy delivered to objective lenses 234, each of which directs a respective sub-beam 211, 212, 213 onto the sample 208. The control lenses pre-focus the sub-beams (e.g. apply a focusing action to the sub-beams prior to the sub-beams reaching the objective lenses 234). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. Note that the reference to demagnification and opening angle is intended to refer to variation of the same parameter.

The objective lenses 234 are arranged in an objective lens array. The objective lenses 234 can be configured to demagnify the electron beam by a factor greater than 10, desirably in the range of 50 to 100 or more. In an arrangement, the objective lenses 234 may be Einzel lenses.

In an arrangement, an electron detection device 240 is provided between the objective lenses 234 and the sample 208 to detect secondary and/or backscattered electrons emitted from the sample 208. Additionally, or alternatively, the electron detection device may have an array of detector elements up beam of the objective lens array and control lens array and/or between the upbeam most of electrode of the control lens array and the down beam most electrode of the objective lens array. An exemplary construction of the electron detection system is described below.

Optionally an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The electron-optical device of FIG. 4 can be configured to control the landing energy of the electrons on the sample. The landing energy can be selected to increase emission and detection of secondary electrons dependent on the nature of the sample being assessed. A controller provided to control the objective lenses 234 may be configured to control the landing energy by varying the potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. A controller may be configured to control the landing energy to any desired value within a predetermined range or to a desired one of a plurality of predetermined values. In an embodiment, the landing energy can be controlled to desired value in the range of from 1000 eV to 5000 eV.

Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The use of the control lens array enables the objective lens array to be operated at its optimal electric field strength. Details of electrode structures and potentials that can be used to control landing energy are disclosed in EPA 20158804.3, which document is incorporated herein by reference.

The objective lenses 234 may have two or more electrodes. The beam energy on entering an objective lens can be different from its energy leaving the objective lens, for example to provide a decelerating objective lens. Further in using two electrodes as few electrodes are used as possible, enabling the lens array to take a smaller volume.

In an embodiment, the charged particle device 41 further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane). The sub-beams have a smallest sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane). However, sensitivity of the aberration correctors for field curvature or astigmatism correction may become low in or near a focal plane. However, deflectors may be positions in or near a focal plane without significant reduction in charged-particle optical performance of the deflectors.

In an embodiment, aberration correctors positioned in, or directly adjacent to, the intermediate foci (or intermediate image plane or focus points) comprise deflectors to correct for the source 201 appearing to be at different positions for different beams. Correctors can be used to correct macroscopic aberrations resulting from the source that prevent a good alignment between each sub-beam and a corresponding objective lens. In some circumstances it is desirable to position the correctors as far upbeam as possible. In this way, a small angular correction can effect a large displacement at the sample so that weaker correctors can be used. Desirably the correctors are positioned to minimize introduction of additional aberrations.

The aberration correctors may correct other aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses 231 are vertically close or coincident with the beam apertures. That is, correction by the corrector of any angular error will require a smaller positional shift than if the corrector is positioned further downbeam. Correcting such aberrations further downbeam such as at the intermediate foci may be impacted by misalignment between the sub-beams 211, 212, 213 and the correctors. A challenge with positioning correctors at or near the condenser lenses 231, however, is that the sub-beams each have relatively large cross-sectional areas and relatively small pitch at this location, relative to locations further downbeam. In situations with volume restrictions, the corrector array or additional corrector arrays may be located away from these preferred locations, such as between the condenser lens array and the intermediate focus positions.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

The aberration correctors may be CMOS based individual programmable deflectors as disclosed in EP2702595A1 or an array of multipole deflectors as disclosed EP2715768A2, of which the descriptions of the sub-beam manipulators in both documents are hereby incorporated by reference. There may be an aberration corrector of this design for each sub-beam, i.e. an individual beamlet corrector. The individual beamlet correctors may be in an array across the multi-beam, which may be referred to as a corrector array.

In an embodiment the objective lens array referred to in earlier embodiments is an array objective lens. Each element in the array is a micro-lens (for example an objective lens) operating a different beam or group of beams in the multi-beam. An electrostatic array objective lens has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is an two electrode decelerating or an accelerating lens (for example for assessment using backscatter electrons). Each electrode may in its own right be considered as a lens; each electrode may be considered an electron-optical element (or electron-optical component). Between the plates (for example electrodes) of the objective lens array are electrically insulating plates for example made of an insulating material such as ceramic or glass, with one or more apertures for the sub-beams. The apertures in the insulating plates are spaced away from the paths of the beams so as minimize if prevent electrical interaction between the beams long the paths and the surface of a surface of the insulating material. In an arrangement, the objective lens array may be considered to comprises the control lens array.

The bottom electrode of the objective lens may be a chip detector such as a CMOS chip detector integrated into a multi-beam manipulator array. Integration of a detector array into the objective lens replaces a secondary column. The chip is preferably orientated to face the sample (because of the small distance (e.g. 100µm) between sample and bottom of the electron-optical system). In an embodiment, capture electrodes to capture the secondary electron signals are provided. The capture electrodes can be formed in the metal layer of a device on and/or in the chip, for example, a CMOS device. The capture electrode may form the bottom layer of the objective lens. The capture electrode may form the bottom surface in the detector chip, e.g. a CMOS chip. The CMOS chip may be a CMOS chip detector. The chip e.g. the CMOS chip may be integrated into the sample facing surface of an objective lens assembly. The capture electrodes are examples of sensor units for detecting secondary electrons. The capture electrodes can be formed in other layers. Power and control signals of the integrated device on the chip, e.g. the CMOS may be connected to the integrated devices by through-silicon vias. For robustness, preferably the bottom electrode consist of two components: the chip and a passive plate, for example comprising silicon, with holes. The plate shields the chip (at least the integrated devices) from high E-fields.

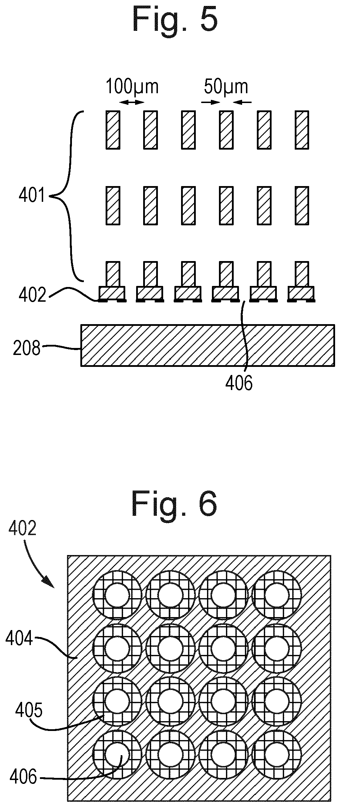

An exemplary embodiment is shown in **FIG. 5** which illustrates a multibeam objective lens 401 in schematic cross section. On the output side of the objective lens 401, the side facing the sample 208, a detector module 402 is provided. The detector module 402 is an example of an electron detection device. **FIG. 6** is a bottom view of detector module 402 which comprises a substrate 404 on which are provided a plurality of capture electrodes 405 each surrounding a beam aperture 406. Beam apertures 406 are large enough not to block any of the primary electron beams. Capture electrodes 405 can be considered as examples of sensor units which receive back-scattered or secondary electrodes and generate a detection signal, in this case an electric current. The beam apertures 406 may be formed by etching through substrate 404. In the arrangement shown in **FIG. 6****,** the beam apertures 406 are shown in a rectangular array. The beam apertures 406 can also be differently arranged, e.g. in a hexagonal array such as a hexagonal close packed arrangement.

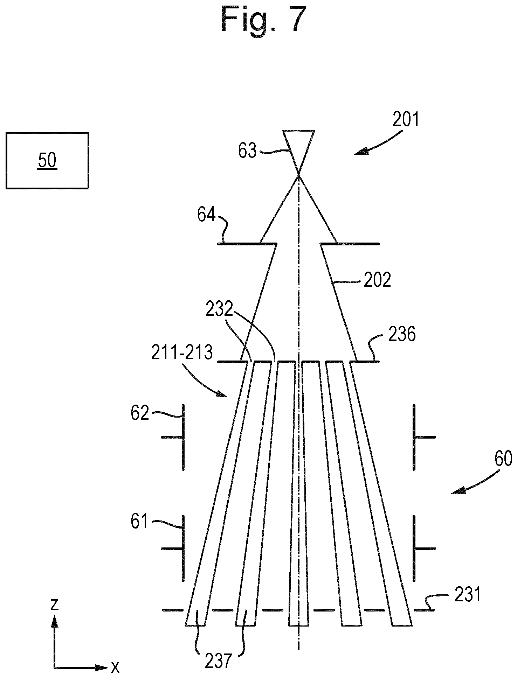

**FIG. 7** is a schematic diagram of an exemplary electron optical apparatus. The electron-optical apparatus is configured to generate a plurality of sub-beams 211-213 from a source beam 202 of electrons. The electron-optical apparatus is configured to direct the sub-beams 211-213 downbeam toward a sample position (i.e. a position occupied by a sample 208). Note the number of beams should neither be limited by three references to the sub-beams nor by the number of sub-beams depicted.

The electron-optical apparatus is configured to project a multi-beam of electrons. The electron-optical apparatus comprises an electron optical device 41. The electron optical device 41 comprises a charged particle-optical module. The electron-optical apparatus may be arranged as described in any of the embodiments described above. The arrangement shown in **FIG. 7** may be provided as part of the arrangement shown in **FIG. 4** or any other suitable design of electron optical device. In other embodiments, the electron-optical apparatus is similar to another of the arrangements described above such as an arrangement comprising a macro collimator and a macro scan deflector instead of the collimator deflectors 235 and the scan deflector array 260.

As shown in **FIG. 7****,** in an embodiment the electron optical device 41 comprises an electron source 201. The electron source 201 is configured to emit (or output) the source beam 202 of electrons. As shown in **FIG. 7****,** in an embodiment the electron source 201 comprises an emitter 63. The emitter 63 is configured to emit the electrons that may be within source beam 202 of electrons.

The electron source 201 may comprise an extractor electrode 64, for example as shown in **FIG. 7****.** The extractor electrode 64 is downbeam of the emitter 63. The extractor electrode 64 may be applied with an electrical potential such that the extractor electrode 64 accelerates electrons away from the emitter 63. The electrons emitted by the emitter (for example within the electron source 201) may be within a divergent path towards the extractor electrode 64. The divergence of the divergent path is shown in **FIG. 7****.** The cross-sectional area of the divergent path increases with increasing distance downbeam of the emitter 63, within the source beam 202.

As shown in **FIG. 7****,** in an embodiment the extractor electrode 64 comprises an aperture. In the extractor electrode may be defined the aperture. The electrode may be a plate. In operation the extractor electrode 64 accelerates the electrons emitted by the emitter 63. The electrons that pass through the aperture defined in the extractor electrode 64 may define the source beam 202. The extractor electrode may thus shape the electrons emitted by the emitter into the source beam. The electrons emitted by the emitter are limited by the extractor electrode to those electrons in the source beam 202. The extractor electrode may be considered to filter a portion of the electrons emitted from the source from onward passage for example in the source beam 202, that do not pass through the aperture in the extractor. For example, a portion of the electrons emitted by the emitter may be blocked by the extractor electrode 64 and, for example from becoming part of the source beam 202.

As shown in **FIG. 7****,** in an embodiment the source beam also has divergent path for example downbeam of the extractor electrode. 64. The source beam has a path that is divergent downbeam of the electron source 201. The source beam 202 may be uncollimated.

As shown in **FIG. 7****,** in an embodiment the electron-optical device comprises aperture arrays. Apertures 232 define a respective aperture array. Apertures may be defined in a plate to define the respective aperture array. A top or most up-beam aperture array is configured to generate sub-beams 211-213 from the source beam 202. The most up-beam plate may be referred to as an aperture array plate or a beam limiter 236. As is known in the art, a beam limiter may be referred to as a beam generator. The beam limiter is positioned in the divergent path. At the beam limiter, the source beam 202 may be divergent. The electron-optical device comprises a plurality of aperture arrays such as between the beam limiter and the sample 208. The apertures of the beam limiter are configured to form a beam grid of sub-beams 211-213 from the source beam 202. The sub-beams of the beam grid are along respective divergent paths. The paths of the sub-beams 211-213 may be divergent downbeam of the beam limiter 236. The sub-beams are along divergent paths because the source beam from which the sub-beams were generated was along its divergent path. The only operation of the beam limiter on the source beam is to generate the sub-beams, so the divergent behaviour is conserved from the source beam to the different sub-beams.

As shown in **FIG. 7****,** in an embodiment the electron-optical device comprises a condenser lens array 231. The condenser lens array 231 is configured to operate on the sub-beams 211-213. As described with reference to and as shown in **FIG. 4****,** the condenser lens array comprises at least two plates. The condenser lens array 231 comprises one or more aperture arrays. The apertures of the aperture arrays may be comprised in a respective plate. In each of the at least two plates, an array of apertures is defined. The apertures correspond to the sub-beams 211-213 for example the apertures of the aperture arrays may be for passage of the respective sub-beams of the beam grid. In other words, each plate of the condenser lens array 231 may define a number of apertures (or beam apertures) equal to a number of sub-beams 211-213. The apertures are configured to operate on the sub-beams 211-213. Each aperture may be configured to operate on a corresponding sub-beam. (Note in the aperture array may be defined one more additional apertures such as vent apertures for fluid conductance through the plate and/or such as dummy apertures for addressing electrostatic edge effects towards the edge of the aperture array for the sub-beams of the beam grid).

The beam limiter 236 is provided separately from the condenser lens array 231. The condenser lens array 231 may be a condenser lens array as described above, for example with reference to **FIG. 3** or **FIG. 4****,** except that unlike the arrangement of **FIG. 4****,** in the arrangement of **FIG. 7** the condenser lens array is separate from the function of generating the sub-beams of the beam grid. The condenser lens array 231 does not function as a beam limiter, beam limiting array, beam shaping array, beam divider, or beam splitter because this function is instead performed by the beam limiter 236. The apertures 232 of the beam limiter 236 may have a dimension, e.g. diameter, smaller than the dimension, e.g. diameter, of the apertures of the aperture arrays of the condenser lens array. In an arrangement the beam limiter has apertures of a smaller dimension to shape the sub-beams with a given dimension. The apertures of the aperture arrays of the condenser lens array may have a dimension larger than the dimension of the apertures of the beam limiter so that the apertures in the condenser lens have a larger dimension that the cross-section of the sub-beams (i.e. as defined by the apertures of the beam limiter).

In an arrangement, the apparatus may be an exemplary multi-beam apparatus 300 as described above in reference to **FIG. 3****.** The beam limiter may be a pre-sub-beam-forming aperture array 372 and/or the beam limiter 321 as shown in and described above in reference to **FIG. 3****.** The condenser lens array may be the condenser lens 310 as described above in reference to **FIG. 3****.**

As mentioned, the beam limiter 236 of **FIG. 7** may be considered to be a top plate or an upbeam plate of a condenser lens arrangement. In such an arrangement, the condenser lens arrangement comprises the beam limiter 236 and the condenser lens array 231. The condenser lens array 231 is desirably at a distance downbeam from the beam limiter 236. In other words, the top plate of the condenser lens arrangement is desirably the most upbeam plate of the condenser lens arrangement, being further upbeam than any plate of the condenser lens array 231. Desirably the distance in a downbeam direction from the beam limiter 236 to the condenser lens array 231 is configured to accommodate one or more electron optical components. Desirably, one or more electron-optical components is disposed between the beam limiter 236 and the condenser lens array 231.

In an alternative arrangement, the condenser lens array 231 comprises the beam limiter 236. In such an arrangement in the condenser lens array 231 are defined apertures to form the sub-beams 211-213 from the source beam 202. An upbeam plate or a top plate of the condenser lens array may serve as the beam limiter 236. In other words, the condenser lens array 231 may perform the dual function of generating the sub-beams 211-213 from the source beam 202 and operating (e.g. acting) on the sub-beams 211-213 as a condenser lens. A separate aperture array plate to operate as the beam limiter 236 is not required. With an alternative arrangement such as this, the condenser lens function is not provided at a distance downbeam from the beam generation function. It has been found that in such an arrangement, even with the apertures of the beam limiter 236 (and upper most plate of the condenser lens array) having a smaller dimension than the apertures of the remaining (or down beam) plates of the condenser lens array, misalignments may occur between the apertures in the beam limiter and the other aperture arrays of the condenser lens array. Misalignments may occur between the aperture arrays of the condenser lens array. Such misalignments may cause the sub-beams interact in an undesirable manner with the down beam plates. For example apertures in one or more of the down beam plates may cause unwanted shaping (or partially blocking) or focusing of one or more of the sub-beams and/or cause aberrations in one or more of the sub-beams. Variations in tolerances of the aperture arrays used for beam limiter and the plates of the condenser lens array has been found to be detrimental to the electron-optical properties of the sub-beams of the beam grid.

Electron-optical components to address unwanted characteristics of the source beam upbeam of the condenser lens array have been proposed, for example to address misalignment of the source beam relative to the aperture array of the condenser lens array, lack of uniformity of the source of the source beam, and astigmatism of the source beam. See WO 2023110316 A1, the disclosure of which is hereby incorporated so far as the disclosure of a corrector between a source and a condenser lens array for example for controlling the alignment of the source beam with the condenser lens array. However, such a corrector operates on the source beam. The ability of a corrector to at address misalignment between the plates of a condenser lens array is restricted and is limited (if possible) because the apertures of the beam limiter fix the relative beam positions. Corrections cannot be achieved to the sub-beams to address tolerance variations. The positions of the sub-beams cannot be adjusted by controlling the source beam to address tolerance variations and/or such misalignments.

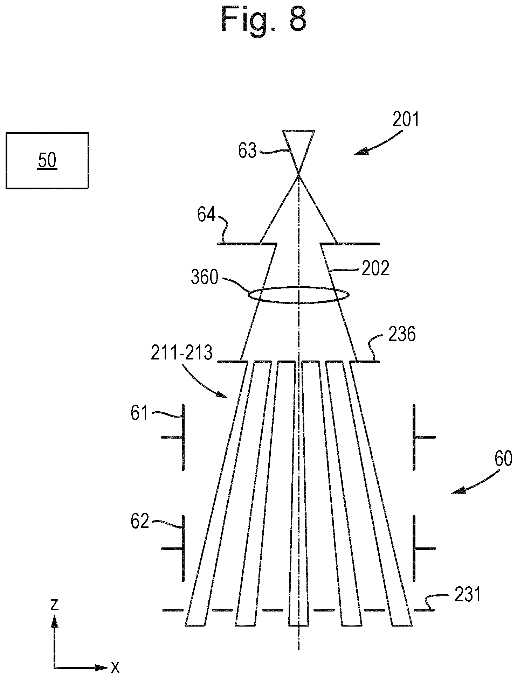

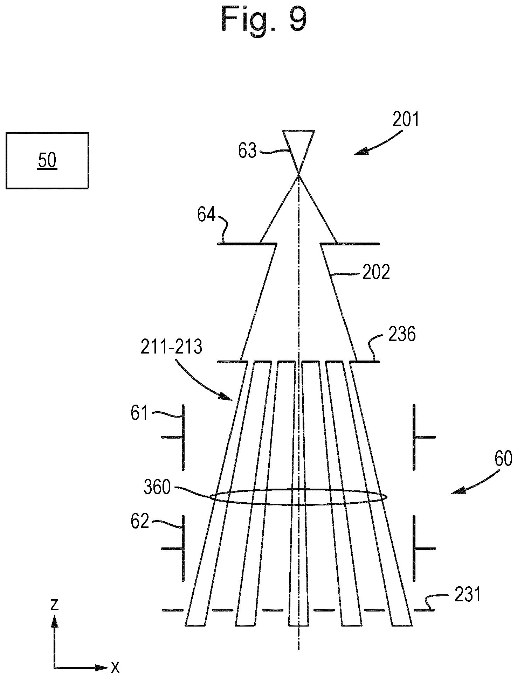

Separating these functions by providing an beam limiter 236 and, further downbeam, a condenser lens array 231 in accordance with the embodiments as shown in **FIG. 7** (and also **FIG. 8** and **FIG. 9****)** may be beneficial. For example, in comparison to the alternative arrangement where the condenser lens array 231 is used to form the sub-beams, with the arrangement of **FIG. 7** the sub-beams may be formed closer to the emitter 63. This is because there is a beam limiter 236 which is disposed further upbeam than the plates of the condenser lens array 231. This positioning of the sub-beam generation function closer to the emitter may beneficially reduce Coulomb interaction effects because of smaller distance from the source 201 to the beam limiter. The distance traveled by the source beam 202 is shorter; the source beam 202 having a larger beam current than the sub-beams.

Having a separate beam limiter 236 a part from the condenser lens array 231 beneficially enables one or more correctors (each of which may comprise one more corrector elements), to be provided between the beam limiter 236 and the condenser lens array 231 to act on the sub-beams 211-213. Such correctors may form part of a macro-corrector system configured to act on the grid of sub-beams 211-213. The presence of a corrector of the macro-corrector system between the beam limiter 236 and the condenser lens array 231 may enable the sub-beams 211-213 to be controlled for a desired, or preferred, purpose. For example, the sub-beams 211-213 may be adjusted for example to be directed in a preferred direction or towards a preferred position by one or more correctors. The at least one of the correctors may be between the beam limiter 236 and the condenser lens array 231. The introduction of the one or more correctors (for example comprising one more corrector elements) may beneficially enable the apparatus to compensate for any cause of aberration, such as misalignment, for example between the beam limiter 236 and the condenser lens array 231. Since the corrector is between the beam limiter 236 and the condenser lens array 231, the corrector is able to operate on the sub-beams after generation of the sub-beams. The sub-beams are no longer defined by the beam limiter 236, the corrector is capable of operating on the sub-beams after the sub-beams are formed and before they reach the condenser lens array 231. Operation of a corrector direct the sub-beams to pass through the apertures of the condenser lens array with a reduced if not prevented undesired interaction between the sub beams and the plates of the condenser lens array 231.

In the arrangement of **FIG. 7** the electron-optical device comprises a macro-corrector system 60. The macro-corrector system 60 is configured to act on the sub-beams 211-213. The macro-corrector system is at least partly comprised between the beam limiter 236 and the condenser lens array 231. The macro-corrector system 60 is configured to operate on the grid of sub-beams 211-213. The macro-corrector system 60 is desirably configured to have the function of a lens, stigmator and/or deflector. In other words, the macro-corrector system may be configured to focus, shape, stigmate and/or steer (or deflect) the sub-beams 211-213. In another embodiment, the macro-corrector system 60 may be configured to act on the source beam 202, in addition to being configured to act on the sub-beams 211-213. For example, the macro-corrector system may be configured to focus, shape, stigmate and/or steer (or deflect) the source beam 202.

The macro-corrector system 60 comprises at least one electron-optical component. The at least one electron-optical component desirably comprise one or more correctors. The one or more correctors desirably comprise multiple corrector elements. A plurality of the correctors (and the corrector elements of the same and/or of different correctors) may be configured to contribute to the same correction function.

In an embodiment the at least one electron-optical component comprises at least one multipole. Such a multipole comprises a plurality of electrostatic and/or magnetic elements such as electrodes. The multipole is desirably configured to operate on the sub-beams 211-213 to vary the positions and/or angular directions of the divergent path of the grid of sub-beams 211-213. The multipole is desirably configured to operate on the sub-beams 211-213 to vary the positions and/or angular directions of the divergent path of the grid of sub-beams 211-213 at the condenser lens array 231. Alternatively, or additionally, the multipole may be configured to operate on the sub-beams 211-213 to vary a cross-sectional shape of the divergent path of the grid of sub-beams 211-213 at the condenser lens array. The multipole may be disposed between the beam limiter 236 and the condenser lens array 231.

For example, as shown in **FIG. 7****,** in an embodiment the macro-corrector system 60 comprises a first multipole 61 (or up beam multipole) and a second multipole 62 (or a down beam multipole). In an embodiment the first multipole 61 and the second multipole 62 are configured to operate on the sub-beams 211-213. The first multipole 61 and the second multipole 62 may be each be configured to operate on the sub-beams 211-213 so as to vary the position, angular direction (or angle) and/or the cross-sectional shape of the divergent path of the grid of sub-beams 211-213 at the condenser lens array. In having two multipoles, beneficially the position and angle at condenser lens array 231 may be controlled independently of each other.

In the embodiment of **FIG. 7****,** the first multipole 61 and the second multipole 62 are positioned relative to each other between electron source 201 and the condenser lens array 231. In particular, the first multipole 61 and the second multipole 62 are in the path of the grid of sub-beams 211-213 between the beam limiter 236 and the condenser lens array 231. The first multipole 61 and the second multipole 62 are disposed along the path of the grid of sub-beams 211-213 such that the first multipole 61 is at a position upbeam of the second multipole 62. The first multipole 61 and the second multipole 62 are adjacent each other for example along the path of the beam grid. In other words, in the arrangement of **FIG. 7****,** the first multipole 61 is directly upbeam of the second multipole 62. In an embodiment, there are no electron-optical components disposed between the first multipole 61 and the second multipole 62.

The first multipole 61 and the second multipole 62 are configured to operate on the grid of sub-beams 211-213. The first multipole 61 and the second multipole 62 are desirably configured to operate as a lens. Each of the first multipole 61 and the second multipole 61 may comprise a facing electrode. The facing electrode of the first multipole 61 may be arranged to face the facing electrode of the second multipole 62. A facing surface of the facing electrode of the first multipole 61 may face a facing surface of the facing electrode of the second multipole 62. The facing electrode surfaces are desirably configured to have a lensing function. The lensing function is configured to operate on the grid of sub-beams 211-213. The lensing function is desirably configured to compensate for variations in the distance to object plane such as the source, for example distance between the source 201 and the condenser lens array 231.

In an embodiment at least one of the multipoles comprises a plurality of electrodes around the divergent path. In an embodiment the first multipole 61 and the second multipole 62 form deflectors configured to deflect the grid of sub-beams 211-213 in one or more directions perpendicular to the electron-optical axis. In an embodiment, the first multipole 61 and the second multipole 62 form macro deflectors configured to steer (or deflect) the grid of sub-beams 211-213 along the path of the beams between the beam limiter 236 and the condenser lens array 231. Desirably both the first multipole 61 and the second multipole 62 are present so that the grid of sub-beams 211-213 is steerable with the desirably optimum number of degrees of freedom. For example, the first multipole 61 may be configured to operate across the path of the beam grid in any direction (for example across the beam grid path e.g. with axes in an X-direction and a Y direction). The second multipole 62 may be configured to operate across the beam path of the beam grid in any direction (for example including in the Y-direction orthogonal to the X-direction). The multipoles may operate in all directions rather than having a preferred direction (which is a commonly used design of a deflector) because the misalignment between the plates (and so apertures) of the beam limiter 236 and the condenser lens array 231 is undefined and not known. Having both the first multipole 61 and the second multipole 61 enables the sub-beams to be steered in any direction across the path of the beam grid. The combined action of the two multipoles enables the control of the position and direction of the beams at the beam limiter 236. Such an arrangement may correct for the undefined tolerancing or misalignment effects caused as a consequence of misalignment between the plates of the beam limiter 236 and the condenser lens array 231. The axes in the X-direction and the Y-direction are desirably orthogonal to a Z-direction which may correspond to the path of the bean grid or an axis of the divergent path of the grid of sub-beams 211-213 (which may be a central axis of the divergent path). The direction of the path of the beam grid may be from the source towards the sample; the Z-direction may correspond with an upbeam direction of the source beam 202.

At least one of the multipoles may comprise a plurality of electrodes around an aperture. The aperture is desirably defined in a plate. The aperture may be dimensioned for passage of the diverging path of the grid of sub-beams 211-213. In other words, the aperture may be dimensioned to accommodate the grid of sub-beams 211-213, accounting for the diverging path of the grid of sub-beams 211-213 and the distance of the multipole from the beam limiter 236. The aperture may be dimension to accommodate a change of the grid position of sub-beams when operated on by a corrector of the macro-corrector system such as when the beam grid is deflected by the multipole. The multipole may be electrostatic. The number of electrodes is desirably a factor of four, or a factor of two larger than four. The minimum number of electrodes enables a multipole to deflect the beam in a direction in a plane across the path of the beam grid. A greater number of electrodes enables deflection, for example steering, of the sub-beams of the beam grid with a lower risk of inducing aberrations (i.e. unwanted characteristics) in the sub-beams. The electrodes (e.g. around the aperture and/or of the plurality of electrodes), are desirably operated independently. The electrodes configured to be operated at respective potentials so as to function as a deflector. The applied potentials applied to the different electrodes are controllable. The potentials may be controlled independently of each other. In an arrangement at least one of the multipoles may be magnetic comprising a plurality of coils and/or magnetic poles configured to be operable at independently controllable currents to form a deflector. The electromagnetic poles of such as multipole may take the form, function and control aspects of the electrodes for an electrostatic multipole. There may be at least four poles. The poles may be controllable and may be independently controllable for example by supply of a current to a coil of each pole.

Although two multipoles operating as deflectors may be used to steer the sub-beams of the multibeam to compensate for misalignment between the different plates of the beam limiter 236 and the different plates of the condenser lens array and for tolerance limitations of at least one of the plates, one multipole may be sufficient. In such an arrangement of one multipole, at least one of the plates e.g. the beam limiter and/or one or more of the plates of the condenser lens array is mechanically adjustable. Such a mechanically adjustable plate may lateral position the plate and the apertures defined therein. Such a plate may have an actuator to laterally actuate the plate. The actuator may be controllable for example by the controller. Actuation of the plate may be controlled at the same time as actuation of the multipole to deflect the sub-beams of the beam grid. The actuation of the plate and the of the multipole may be controlled to steer the sub-beams. The sub-beams of the beam grid may be steered in their passage from the beam limiter 236 towards the apertures in the plates of the condenser lens array. The sub-beams may be directed through the apertures of the condenser lens array 231.

In another embodiment, the charged particle optical module of the charged particle optical device may optionally further comprise a further multipole, in addition to comprising a first multipole 61 and a second multipole 62. The further multipole is positioned between the electron source 201 and the condenser lens array 231. The further multipole desirably positioned between the beam limiter 236 and the condenser lens array 231. Alternatively, or additionally, a further multipole may be positioned between the electron source 201 and the beam limiter 236, desirably between the emitter 63 and the beam limiter 236.

As shown in **FIG. 7****,** in an embodiment the electron-optical device comprises a corrector controller which may be part of the controller 50 for the assessment apparatus. The corrector controller is configured to control the macro-corrector system 60 so as to control at least one property of the sub-beams 211-213.

In another embodiment, the macro-corrector system 60 may be configured to operate on the source beam 202. The macro-corrector system may comprise at least one electron-optical component configured to act on the source beam 202 upbeam of the beam limiter 236. Any such component (e.g. corrector) of the macro-corrector system may be additional to corrector (e.g. component) of the macro-corrector system between the beam limiter 236 and the condenser lens array, such a multipole 61, 62. The at least one electron-optical component is disposed between the electron source and the beam limiter 236. The at least one electron-optical component is optionally between the emitter 63 and the beam limiter 236. In an arrangement the at least one electron-optical component is between the extractor electrode 64 and the beam limiter 236. In such an embodiment the at least one electron-optical component is desirably configured to control one or more characteristics of the source beam 202. The at least one electron-optical component may be configured to control one or more characteristics of the source beam 202 incident on the beam limiter 236. The at least one electron-optical component may comprise a multipole, optionally a plurality of multipoles. The multipole is desirably configured to operate on the source beam 202 so as to vary the position of the divergent path at the aperture array and/or to vary a cross-sectional shape of the divergent path at the beam limiter. For example, a first multipole and a second multipole may form macro deflectors configured to steer the source beam 202 between the electron source 201 and the beam limiter 236. Thus electrons in the source beam may be steered at a position between the emitter 63 and the beam limiter 236. Such correctors may be positioned between the extractor electrode 64 and the beam limiter 236.

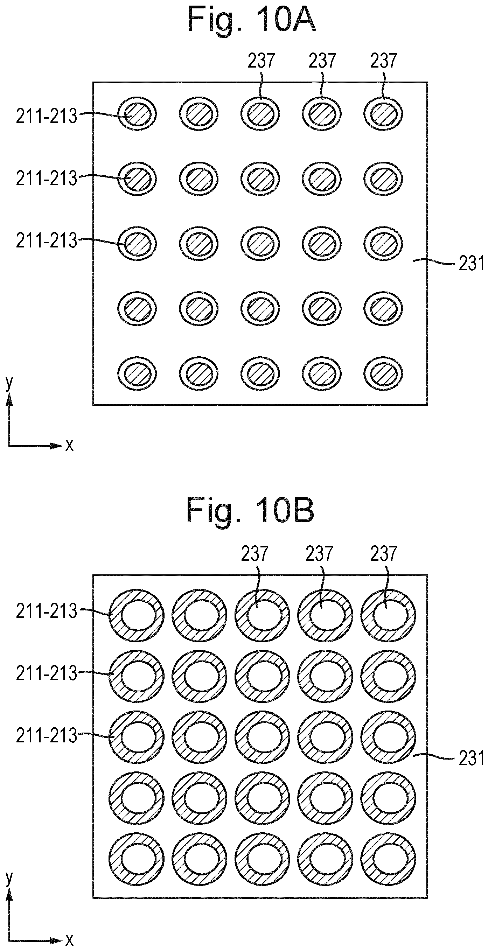

The macro-corrector system is configured to have a lensing function. In an embodiment the lensing function acts between the electron source 201 and the condenser lens array 231. The lensing function may act between the electron source 201 and the beam limiter 236. The lensing function may operate on the source beam 202. In a different embodiment, the lensing function acts between the beam limiter 236 and the condenser lens array 231. In other words, the lensing function may be configured to operate on the grid of sub-beams 211-213. The lensing function may operate in multiple locations between the source 201 and the condenser lens array 231. The macro-corrector system 60 may comprise one or more multipoles configured to provide the lensing function. For example, in the arrangement of **FIG. 7****,** the first multipole 61 and the second multipole 62 may be configured to provide the lensing function. The lensing function may be applied by the poles or electrodes of the different multipoles and/or between adjoining surfaces or facing surfaces of adjoining multiples such as the first multiple and the second multipole. Such adjoining surfaces may face each other. A potential may be applied between the adjoining surfaces for the lensing function. The applied potential may be controlled to control the effect of the lensing function. Lensing function may be applied in order to reduce or mitigate undesirable beam arrangements. For example, beams having a greater or smaller cross-sectional dimension than is intended at a particular location along the path of the sub-beams. For example, the lensing function may be used to reduce or mitigate focus error (as described further below with reference to **FIG. 10B****).**

**FIG. 8** and **FIG. 9** are schematic diagrams of exemplary electron optical apparatus. The electron optical apparatus of **FIG. 8** and **of** **FIG. 9** comprise all of the features described above in relation to **FIG. 7****.** Like features have similar references. The only difference between the arrangements of **FIG. 7** and the arrangements depicted in **FIG. 8** and **FIG. 9** is that in the electron optical apparatus of **FIG. 8** and **FIG. 9** the macro-corrector system further comprises a charged-particle-optical lens 360. The charged particle optical lens 360 may be an element (or a corrector element) of the corrector (or otherwise expressed as the macro-corrector system). The charged-particle-optical lens 360 may comprise or even be a macro lens component.

The charged-particle-optical lens 360 is desirably configured to provide a lensing function. For example, the charged-particle-optical lens 360 may be configured to compensate for variations in distance between the emitter 63 and the condenser lens array 231. It is possible for the position of the emitter 63 to shift over time (which may be referred to as drift). The charged-particle-optical lens 360 is desirably configured to correct for such a shift in the position of the emitter 63.

In the arrangement of **FIG. 8****,** the charged-particle-optical lens 360 is disposed between the emitter 63 and the beam limiter 236. The charged-particle-optical lens 360 of **FIG. 8** is arranged to act on the source beam 202. The charged-particle-optical lens 360 of **FIG. 8** may be configured to vary an angle of divergence of the source beam 202. Additionally, or alternatively, the charged-particle-optical lens 360 of **FIG. 8** may be configured to vary a proportion of coverage of the array of apertures of the beam limiter 236 by the source beam 202.

In the arrangement of **FIG. 9****,** the charged-particle-optical lens 360 is disposed between the beam limiter 236 and the condenser lens array 231. In particular, in the example arrangement of **FIG. 9** the charged-particle-optical lens 360 is disposed between the first multipole 61 and the second multipole 62. The charged-particle-optical lens 360 of **FIG. 9** is arranged to act on the sub-beams 211-213. The charged-particle-optical lens 360 of **FIG. 9** may be configured to vary an angle of divergence of the sub-beams 211-213. Additionally, or alternatively, the charged-particle-optical lens 360 of **FIG. 9** may be configured to vary a proportion of coverage (i.e. filling) of the array of apertures of one or more plates of the condenser lens array 231 by the sub-beams 211-213. For example the charged particle optical lens 360 may be configured to vary the proportion of the filling of an aperture in a plate of the condenser lens by the corresponding sub-beam of the beam grid.

In alternative arrangements (not shown in the figures), the charged-particle-optical lens 360 may be provided at a different position than those depicted in **FIG.** 8 and **FIG.** 9. For example, the charged-particle-optical lens 360 may be disposed between the beam limiter 236 and the first multipole 61. Alternatively, or additionally, a charged-particle-optical lens 360 may be between the second multipole 62 and the condenser lens array 231.

Furthermore, a plurality of charged-particle-optical lenses may be provided at different positions. For example, a charged-particle-optical lens may be configured to act on the source beam 202. The charged-particle-optical lens may be disposed between the emitter 63 and the beam limiter 236. Another charged-particle-optical lens may be configured to act on the sub-beams 211-213. The other charged particle-optical lens may be disposed between the beam limiter 236 and the condenser lens array 231.

It may be desirable to have the charged-particle-optical lens 360, when positioned between the beam limiter 236 and the condenser lens array 231, to be located between the first multipole 61 and second multipole 62. This is because the positioning of the multipoles (operational as deflectors) relative to the paths of the sub-beams may be adjusted without disturbance to the characteristics of the sub-beams. Adjustment such as alignment of the lens with respect to the sub-beams and the beam grid of the sub-beams may be achieved without need to consider other factors such as the alignment (or extent of misalignment) of the different plates of the beam limiter 236 and the condenser lens array 231 and also their tolerances.

The condenser lens array 231 as shown in and described with reference to **FIG. 4** may formed of three plates. The three plates may be configured such that charged particles have the same energy as they enter and leave each lens, which arrangement may be referred to as an Einzel lens. The beam energy is the same on entering as leaving the Einzel lens.

In an arrangement, at least one of the plates of the condenser lens array 360 is a macro-component. In the plate of the macro-component is defined an aperture. The aperture in the plate of the macro-component may be for a path of the plurality of sub-beams 211-213. In other words, the aperture may surround the path of the beam grid. A condenser lens array with such a plate with a macro aperture may reduce the risk of unwanted interaction between the condenser lens array and the sub-beams of the beam grid. For example the risk of misalignment and/or tolerance variation of features such as the shape and position of the apertures may be reduced if the aperture array is defined in at least one of the plates of by a macro aperture. For example the risk of unwanted shaping of a sub-beam by a plate of the condenser lens array may be reduced. The macro-aperture may provide for acceptance of larger tolerances between features of other plates of the condenser lens array.

At least two plates of the condenser lens array 231 may define a plurality of apertures 237. The apertures 237 are desirably disposed at corresponding positions. In other words, each aperture of one of the at least two plates may correspond to an aperture of another of the at least two plates. In particular, each aperture of each plate of the condenser lens array 231 may correspond to an aperture of the beam limiter 236. The positions of the corresponding apertures of each plate of the condenser lens array 231 desirably account for the divergent path of the grid of sub-beams 211-213. For example, the position of the apertures 237 of an uppermost plate of the condenser lens array 231 may be closer to the axis of the divergent path of the grid of sub-beams 211-213 than the position of the corresponding apertures of another plate, downbeam of the uppermost plate, of the condenser lens array 231.

The macro-corrector system 60 is configured to operate on the sub-beams 211-213 to compensate for misalignment in the charged particle optical device. In particular, the macro-corrector system 60 is desirably configured to compensate for misalignment between the apertures of different plates of the beam limiter 236 and/or the condenser lens array 231 that operate on the same sub-beam. Additionally, or alternatively, the macro-corrector system 60 may be configured to compensate for variations in dimensional tolerances of the apertures. The misalignment may be a misalignment between the beam limiter 236 and any of the plates of the condenser lens array 231, for example between the beam limiter 236 and the uppermost plate of the condenser lens array 231. Alternatively, or additionally, the misalignment may be a misalignment between two of the plates of the condenser lens array 321.

**FIG. 10A-D** show different possible arrangements of sub-beams 211-213 at the condenser lens array 231. The condenser lens array 231 comprises a plurality of apertures 237, desirably arranged in an array. In other words, the condenser lens array 231 may define an array of apertures. In particular, **FIG. 10A-D** show different possible arrangements of sub-beams 211-213 at an uppermost plate of the at least two plates of the condenser lens array 231 for example in which the aperture array is defined. (Note: there may be a further plate the macro component). The uppermost plate is the plate disposed furthest upbeam among the plates of the condenser lens array 231.

**FIG. 10A** shows a schematic representation of an arrangement with the sub-beams 211-213 having an even uniformity. It may be preferred that the cross-section of the sub-beams have even uniformity such as in shape, dimension and/or position relative to the apertures of the condenser lens array. In practice, there may be some variation in beam uniformity from sub-beam to sub-beam. In this preferred arrangement, the sub-beams 211-213 have a smaller dimension than the apertures 237 of the condenser lens array 231. In particular, a diameter of each sub-beam 211-213 at the condenser lens array 231 is smaller than a diameter of a corresponding apertures 237 of the condenser lens array 231, as described earlier herein with reference to **FIG. 7****.** Due to the grid of sub-beams 211-213 having a divergent path, the position and diameter of the sub-beams 211-213 upbeam and/or downbeam of the condenser lens array 231 may be different than illustrated in **FIG. 10A****.**

The macro-corrector system 60 may be configured to act on the sub-beams 211-213 to vary a direction of the sub-beams 211-213. Alternatively, or additionally, the macro-corrector system 60 may be configured to vary a position of the sub-beams 211-213. The macro-corrector 60 is at least partially disposed between the beam limiter 236 and the condenser lens array 231. The macro-corrector system 60 desirably comprises at least one corrector, for example a first multipole 61 and optionally also a second multipole 62, disposed between the beam limiter 236 and the condenser lens array 231. (For example when only one multipole 61 is present, a plate of the condenser lens arrangement such as a plate of the beam limiter 236 and/or of the condenser lens may be actuatable in a direction across the path of the beam grid). In this way, the macro-corrector system 60 may contribute to achieving the preferred arrangement of sub-beams 211-213 as shown in **FIG. 10A****.** The macro-corrector may be used to optimize the electron-optical characteristics of the sub-beams at a position along the path of the beam grid for example the uniformity of the different sub-beams of the beam grid.

The beam limiter 236 and the condenser lens array 231 may be configured to achieve the preferred arrangement of sub-beams 211-213 on the condenser lens array 231 as shown in **FIG. 10A** (for example substantial uniformity of the different sub-beams of the beam grid and between the sub-beams of the beam grid; that is there are minimum variation between sub-beams). The apertures 237 defined in an uppermost plate of the at least two plates of the condenser lens array 231 may have a larger dimension than a corresponding dimension of apertures defined in the beam limiter 236. In this way, the cross-sectional dimension (e.g., the diameter) of the sub-beams 211-213 at the condenser lens array 231 may be smaller than the apertures 237 defined in the condenser lens array 231 in spite of the grid of sub-beams 211-213 following a diverging path between the beam limiter 236 and the condenser lens array 231. In particular, it is desirable that each aperture defined in the uppermost plate of the condenser lens array 231 has a larger dimension than the corresponding dimension of each corresponding aperture defined in the beam limiter 236. In other words, desirably the dimension of an aperture in the beam limiter 236 for defining a respective sub-beam is smaller than a dimension of a corresponding aperture 237 in the uppermost plate of the condenser lens array 231 that operates on the same sub-beam. This arrangement may beneficially aid in controlling position and/or direction of the sub-beams 211-213. For example it may assist in avoiding if not in preventing the apertures of any of the plates of the condenser lens array 231 from shaping (e.g. blocking any part) of a sub-beam having a path through the aperture. It may therefore be desirable to provide a configuration wherein the apertures 237 defined in an uppermost plate of the at least two plates of the condenser lens array 231 have a larger dimension than a corresponding dimension of apertures defined in the beam limiter 236. The macro-corrector system 60 further may be configured to act on the sub-beams 211-213 to vary a position and/or direction of the sub-beams 211-213. The action of the macro-corrector 60 in such an arrangement may have improved control, since the cross-sections of the sub-beams are shaped to be smaller than the apertures defined in any of the plates of the condenser lens array 231.

Furthermore, a distance between apertures 237 of the uppermost plate of the condenser lens array 231 may be greater than a distance between apertures of the beam limiter 236. In other words, the pitch of apertures of the uppermost plate of the condenser lens array 231 may be greater than the pitch of apertures of the beam limiter 236. In particular, a distance between a common feature of two adjoining apertures in the uppermost plate of the condenser lens array 231 may be greater than a distance between the same common features of corresponding adjoining apertures of the beam limiter 236. For example, a distance between a center of an aperture of the uppermost plate of the condenser lens array 231 and a center of an adjacent aperture of the uppermost plate of the condenser lens array 231 may be greater than a distance between a center of a corresponding aperture of the beam limiter 236 and a center of a corresponding adjacent aperture of the beam limiter 236. The aperture of condenser lens array 231 is configured to operate on a sub-beam generated by the corresponding aperture of the beam limiter 236. The adjacent aperture of condenser lens array 231 is configured to operate on a sub-beam generated by the corresponding adjacent aperture of the beam limiter 236. In an arrangement, the position of apertures of the condenser lens array 231 may be a greater distance from the axis of the divergent path than the corresponding apertures of the beam limiter 236. The axis of the divergent path desirably may be a central axis through the path of the grid of sub-beams 211-213 between the beam limiter 236 and the condenser lens array 231 as described earlier herein.

**FIG. 10B** shows the result of a focus error. The sub-beams 211-213 are inappropriately focused at the condenser lens array 231. In this example, the focus error is such that the dimension of the sub-beams 211-213 at the condenser lens array 231 is greater than is desirable. In this example, the dimension of the sub-beams 211-213 at the condenser lens array 231 is greater than the dimension of the corresponding apertures 237 of the condenser lens array 231. In particular, the diameter of the sub-beams 211-213 at the condenser lens array 231 is greater than the diameter of the corresponding apertures 237 of the condenser lens array 231. This may result in the sub-beams 211-213 being incident on a plate of the condenser lens array 231 in which the apertures 237 are defined. In other words, each sub-beam 211-213 may not entirely pass through a corresponding aperture 237 of the condenser lens array 231 as intended. As a consequence at least one of the plates of the condenser lens array 231 serves to shape the sub-beams that pass down beam of the condenser les array. The plates may in effect limit or partially block the sub-beams which extend beyond (or down beam of) the respective apertures onto the surface of a plate of the condenser lens array 231. In a different focus error (not shown) the dimension of the sub-beams 211-213 at the condenser lens array 231 may be smaller than is desirable.

The macro-corrector system is desirably configured to have a lensing function to compensate for a focus error. For example, the macro-corrector system 60 may comprise one or more multipoles configured to provide the lensing function. For example, in the arrangement of **FIG. 7****,** the first multipole 61 and the second multipole 62 may be configured to provide the lensing function and/or a potential applied between the first multipole 61 and the second multipole 62 Alternatively or additionally, the charged-particle-optical lens 360 (which may be a separate component from the first multipole 61 and the second multipole 62) may be configured to provide the lensing function. The charged particle lens 360 may be located (for example as shown in and described with reference to **FIGs. 8** **and** **9****)** above the beam limiter 236, down beam of the beam limiter 236 or have components up beam and down beam of the beam limiter 236. In this way, focus errors may beneficially be reduced or avoided.

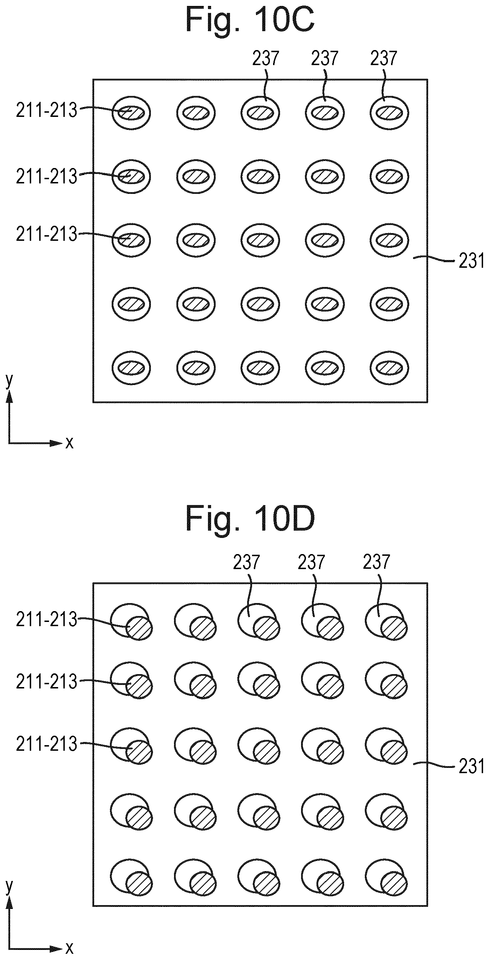

**FIG. 10C** shows the result of astigmatism. In such an astigmatism, the sub-beams 211-213 have a shape other than circular at the condenser lens array 231 for example a shape perturbed from a circular shape. In other words, the cross-sectional shape of the sub-beams 211-213 at the condenser lens array 231 is non-circular. In this example, the cross-sectional shape of the sub-beams 211-213 at the condenser lens array 231 is elliptical for a two-fold astigmatism. It is possible for the cross-sectional shape of the sub-beams to display higher orders of astigmatism, such as three-fold or fourfold astigmatism. In particular, each of the sub-beams 211-213 has a non-circular cross-sectional shape at the condenser lens array 231.

The macro-corrector system 60 may beneficially be configured to operate on the sub-beams 211-213 to compensate for astigmatism of the sub-beams 211-213. For example, one or more multipoles 61, 62 may be provided, for example controlled, to act on the source-beam 202, desirably to alternatively or additionally act on the sub-beams 211-213, to compensate for the astigmatism. In this way, astigmatism may beneficially be reduced or avoided. Thus the function of astigmatism correction (as an astigmatism corrector) may be achieved by controlling the different poles and/or electrodes of the respective multipole. Such an astigmatism corrector may be located at any location at which a multipole may be located, for example between the source 202 and the condenser lens array 231, such as between the source 202 and the beam limiter 236, between the beam limiter 236 and the condenser lens array, or as two correctors located either side of the beam limiter 236. Desirably all or part of the astigmatism correction may be made by one or both of the first and second multipole 61, 62.

**FIG. 10D** shows the result of tilt and/or shift error,. In such a tilt and/or shift error the sub-beams 211-213 are unaligned or misaligned with the corresponding apertures 237 of the condenser lens array 231. In other words, a center of each sub-beam 211-213 at the condenser lens array 231 is misaligned with a center of the corresponding aperture 237 of the condenser lens array 231. In this example, the sub-beams 211-213 are offset from the apertures 237 at the condenser lens array 231 for example in a diagonal direction with respect to the corresponding aperture of the array of apertures. That is the position of the sub-beams of the beam grid are misaligned with the apertures of the aperture array in the condenser lens array. The beam gird s in effect misaligned with the aperture array. In other words, in the arrangement of **FIG. 10D** the apertures 237 of the condenser lens array 231 are arranged in a two-dimensional array. In an array having a rectangular arrangement the apertures may extend along axes of two different directions, for example extending in an X-direction and a Y-direction which may be orthogonal to the X-direction. In the arrangement of **FIG. 10D****,** the sub-beams 211-213 are all offset from the corresponding apertures 237 in both the X-direction and the Y-direction. In an arrangement with a hexagonal arrangement of the apertures in the aperture array (and also the beams of the beam grid), such an offset in two orthogonal coordinate axes can be envisaged, for example off set in the X direction and the Y direction. The offset is independent of the arrangement of the apertures in the aperture array. However, the offset is exemplary and an offset of a sub-beam of the beam grid relative to an aperture of the aperture array in the condenser lens array may be in any direction around a perimeter of such an aperture.

The shift of sub-beam positions as shown in **FIG. 10D** may for example be caused by a misalignment between the apertures of different plates of the beam limiter 236 and/or the condenser lens array 231. The macro-corrector system 60 may beneficially be configured to operate on the sub-beams 211-213 to compensate for misalignment in the charged particle optical device. For example, one or more multipoles 61, 62 and/or one or more charged-particle-optical lenses 360 may be provided to act on the sub-beams 211-213, to compensate for the misalignment, such as by varying a direction or position of the sub-beams 211-213. Note, with a single multipole corrector between the beam limiter 236 and the condenser lens array 231, one or more of the plates of the beam limiter array and/or condenser lens array is actuatable across the path of the beam grid. Optionally the macro-corrector system 60 may further comprise one or more multipoles 61, 62 positioned up beam of the beam limiter 236 to operate on the source-beam 202. In an embodiment, the macro-corrector system 60 may comprise a one or more charged particle optical lenses 360 up beam of the beam limiter 236 alternatively or additionally to one or more charged particle optical lenses 360 positioned down beam of the beam limiter 236. In this way, tilt and/or shift errors may beneficially be reduced or avoided.

In an embodiment there is a method of using the charged-particle apparatus to generate a plurality of sub-beams 211-213 from a source beam 202 of charged particles and direct the sub-beams 211-213 downbeam toward a sample position. The method comprises emitting a source beam 202 of charged particles along a divergent path. In other words, a cross-sectional dimension of the source beam 202 increases with increasing downbeam distance from the electron source 201. The method further includes forming a plurality of sub-beams 211-213 from the source beam 202. The sub-beams are formed using an aperture array plate (or beam limiter 236) defining an array of apertures. The array of apertures may be arranged in a grid pattern, such as of rectangular or hexagonal form, such that the plurality of sub-beams 211-213 may be described as being arranged as a grid of sub-beams 211-213. The method further comprises operating on the sub-beams using a condenser lens array 231. In particular, the condenser lens array 231 comprises at least two plates in which are each defined an array of apertures corresponding to the sub-beams. Each aperture 237 of the condenser lens array 231 may correspond to a corresponding sub-beam of the grid of sub-beams 211-213, such that the apertures 237 operate on the sub-beams 211-213. The method further comprises acting on the sub-beams 211-213 using a macro-corrector system 60. At least part of the macro-corrector system being between the beam limiter 236 and the condenser lens array 231. The method may be performed using an apparatus comprising the device, or module, of any of **FIG. 7-9** as described above.

An electron-optical apparatus according to an embodiment of the invention may be an apparatus which makes a qualitative assessment of a sample (e.g. pass/fail), one which makes a quantitative measurement (e.g. the size of a feature) of a sample or one which generates an image of map of a sample. Examples of electron-optical apparatuses are used in assessment systems. Such assessment systems may be an assessment system (e.g. for identifying defects), a review system (e.g. for classifying defects) and metrology system, or a system (or tool) capable of performing any combination of assessment functionalities associated with the aforementioned functions and application such as in an assessment tool, a review tool, or a metrology tool. The electron optical device 41 (which may comprise an electron optical column) may be a component of an assessment system, such as an assessment tool or a metrology tool, or part of an e-beam lithography system. Any reference to a tool herein is intended to encompass a device, apparatus or system, the tool comprising various components which may or may not be collocated, and which may even be located in separate rooms, especially for example for data processing elements.

A multi-beam electron-optical apparatus may comprise a gun aperture plate or Coulomb aperture array 372). The gun aperture plate is a plate in which apertures are defined. It is located in an electron-optical device downbeam of the source and before any other electron-optical device. In **FIG. 7** it would be located between the source 201 and the beam limiter 236. In arrangements having part of the macro-corrector system partially comprised between the source 201 and the beam limiter 236, the gun aperture plate may for example be disposed upbeam, downbeam or integrated into the electron-optical component 60. Thus the gun aperture plate may be upbeam of, downbeam of, or in between, the first multipole 61 and the second multipole 62. The gun aperture plate, in operation, is configured to block off peripheral electrons of the source beam 202 to reduce Coulomb effects in the beam before the beam separator, for example in or associated with the condenser lens array. However, the gun aperture array may have fewer apertures than the condenser lens array and a number of apertures fewer than the number of sub-beams that are down beam in the multi-beam. As a gun aperture array is a type of aperture array and is spaced apart from other beam limiting aperture arrays, such as the condenser lens array and the objective lens array, it may be considered in the alignment procedure too. Such a gun aperture plate may be suited for an electron-optical device for directing a plurality of electron beams towards the sample. The electron-optical device may comprise a macro condenser lens and a macro objective lens each of which may be magnetic. Between the two macro lenses is an aperture plate with associated array electron-optics comprising a plurality of arrays arranged along the paths of the beams. The array electron-optics may be provided in a MEMS stack. Upbeam of the objective lens is a defection arrangement such as a Wien filter to direct secondary electrons generated in response to the plurality of electron beams incident on a sample 208. A detector for detecting the signal particles may be in a second electron-optical device connected.

A multi-beam electron-optical apparatus may comprise a plurality of electron-optical devices (or columns). The multi-beam electron-optical apparatus may be a multi-device (or multi-column) apparatus. The multi-device apparatus may comprise multiple devices each configured to project a plurality of sub-beams of electrons towards a sample position. The multi-device apparatus comprises an electron-optical apparatus as described above comprising a plurality of the sources 201 and a plurality of corresponding electron-optical devices. Each electron-optical device comprises the aperture array and the at least one electron-optical component.

The multi-device apparatus may comprise a controller 50 configured to control the at least one electron-optical component of the plurality of electron-optical devices to control a parameter of the plurality of the source beam at the aperture array plate (or beam limiter) and/or the grid of sub-beams at the condenser lens array. The parameter may be the source beam uniformity, preferably at the corresponding aperture arrays, so as to control the source beam uniformity across the plurality of sources 201.

There are provided the following clauses.

Clause 1. A charged particle-optical module for generating a plurality of sub-beams from a source beam of electrons, the module for use in an charged particle-optical device for projecting a plurality of sub-beams toward a sample, the charged particle module comprising: an electron source comprising an emitter configured to emit a source beam along a divergent path; a beam limiter defining an array of apertures and positioned in the divergent path, wherein the array of apertures are configured to form a grid of sub-beams from the source beam along the divergent path; a condenser lens array configured to operate on the sub-beams, the condenser lens array comprising at least two plates in which are each defined an array of apertures corresponding to the sub-beams and which are configured to operate on the sub-beams; and a macro-corrector system configured to act on the sub-beams, wherein the macro-corrector system is at least partly comprised between the beam limiter and the condenser lens array.

Clause 2. The charged particle-optical module of clause 1, wherein the macro-corrector system comprises a multipole, desirably as a macro-corrector, desirably configured to operate on the grid of sub-beams, desirably positioned between the beam limiter and the condenser lens array.

Clause 3. The charged particle optical module of clause 2, wherein the multipole is configured to operate on the source beam, desirably the multipole is between the electron source and the beam limiter.

Clause 4. The charged particle-optical module of either of clauses 2 and 3, wherein the multipole is configured to operate on the sub-beams to vary the positions and/or angular directions of the divergent path of the grid of sub-beams at the condenser lens array.

Clause 5. The charged particle-optical module of any of clauses 2 to 4, wherein the multipole is configured to operate on the sub-beams to vary a cross-sectional shape of the divergent path of the grid of sub-beams at the condenser lens array.

Clause 6. The charged particle-optical module of any of clauses 2 to 5, wherein the multipole is a first multipole and the macro-corrector system comprises a second multipole, the two multipoles positioned relative to each other between electron source and the condenser lens array desirably long the path of the grid between the beam limiter and the condenser lens array, desirably the two multipoles are adjacent each other, desirably the two multipoles are configured to operate on the grid of sub-beams.

Clause 7. The charged particle-optical module of clause 6, wherein the two multipoles are configured to operate as a lens, desirably the multipoles having respective facing electrode surfaces, desirably the facing electrode surfaces are configured to have a lensing function, desirably the lensing function is configured to operate on the grid of sub-beams.

Clause 8. The charged particle-optical module of clause 7, wherein the two multipoles, desirably the lensing function, desirably of the facing electrode surfaces, are configured to compensate for variations in distance between the emitter and the condenser lens array.

Clause 9. The charged particle optical module of any of clauses 6 to 8, further comprising a further multipole, wherein the further multipole is positioned between the electron source and the condenser lens array, desirably the further multipole is positioned between the electron source and the beam limiter, the further multipole desirably positioned between the beam limiter and the condenser lens array.

Clause 10. The charged particle-optical module of any of clauses 1 to 6, wherein the or at least one plates [such as the beam limiter and at least one of the plates of the condenser lens array] is mechanically adjustable at least laterally across the path of the grid of sub-beams, for example to position the apertures and the paths of the sub-beams relative to each other,

Clause 11. The charged particle optical module of any of clauses 2 to 10, wherein the or any or all of the multipoles comprise a plurality of electrodes around an aperture, the aperture desirably defined in a plate, the electrodes are desirably configured to be independently controllable, the multipole desirably comprises a number of electrodes that is a factor of four or six or ten, the aperture may be dimensioned for passage of the diverging path of the grid of sub-beams.

Clause 12. The charged particle optical module of any preceding clause, wherein the macro-corrector system is configured to have a lensing function desirably between the electron source and the condenser lens array or between the electron source and the beam limiter, desirably between the beam limiter and the condenser lens array, desirably the lensing function is configured to operate on the grid of sub-beams.

Clause 13. The charged particle optical module of any preceding clause, wherein the macro-corrector system comprises a macro lens component, desirably wherein the macro lens component is positioned between the electron source and the beam limiter, desirably between the beam limiter and the condenser lens array, desirably between two multipoles.

Clause 14. The charged particle-optical module of any preceding clause, wherein at least one of the plates of the condenser lens array is a macro-component in which is defined an aperture for a path of a plurality of the sub-beams.

Clause 15. The charged particle-optical module of any preceding clause, wherein the at least two plates of the condenser lens array comprises at least three plates.

Clause 16. The charged particle-optical module of clause 14, wherein the condenser lens array is configured to operate as an Einzel lens.

Clause 17. The charged particle-optical module of any preceding clause, wherein the apertures defined in at least two plates of the condenser lens array are disposed at corresponding positions, desirably the corresponding positions accounts for the divergent path of the grid of sub-beams, desirably the position of such apertures positioned in the array of apertures away from the axis of the divergent path are positioned at corresponding positions to be further from the axis in an individual plate further from the electron source than in an individual plate closer to the electron source.

Clause 18. The charged particle-optical module of any preceding clause, wherein the macro-corrector system is configured to operate on the sub-beams to compensate for: misalignment between the apertures of different plates of the beam limiter and the condenser lens array that operate on the same sub-beam and/or variations in dimensional tolerances of the apertures.

Clause 19. The charged particle-optical module of any preceding clause, wherein the apertures defined in an uppermost plate of the at least two plates of the condenser lens array have a larger dimension, desirably the dimension being a diameter, than a corresponding dimension of apertures defined in the beam limiter; desirably each aperture defined in the uppermost plate has a larger dimension than the corresponding dimension of each corresponding aperture defined in the beam limiter; desirably the dimension of an aperture in the beam limiter for defining a respective sub-beam is smaller than a dimension of a corresponding aperture in the uppermost plate that operates on the same sub-beam; wherein desirably the uppermost plate is disposed furthest upbeam among the plates of the condenser lens array.

Clause 20. The charged particle-optical module of any preceding clause, wherein the macro-corrector system is configured to have the function of a lens, stigmator and/or deflector.

Clause 21. The charged particle-optical module of any preceding clause, wherein the macro-corrector system comprises one or more correctors.

Clause 22. The charged particle-optical module of clause 20, wherein at least one of the correctors is, preferably at least two of the correctors are, located between the electron source and the beam limiter.

Clause 23. The charged particle-optical module of either of clauses 20 and 21, wherein the one or more correctors comprises multiple correctors configured to contribute to the same correction function.

Clause 24. The charged particle-optical module of any of clauses 21 to 23, wherein at least one of the one or more correctors is a charged-particle-optical lens.

Clause 25. The charged particle-optical module of clause 24, wherein the charged-particle-optical lens is configured to compensate for variations in distance between the emitter and the condenser array.

Clause 26. The charged particle-optical module of either of clauses 24 and 25, wherein the charged-particle-optical lens is configured to vary an angle of divergence of the source beam and/or a proportion of coverage of the array of apertures of the beam limiter by the source beam.

Clause 27. The charged particle-optical module of clause 26, wherein the charged-particle-optical lens is disposed between the emitter and the beam limiter.

Clause 28. The charged particle-optical module of either of clauses 24 and 25, wherein the charged-particle-optical lens is configured to vary an angle of divergence of the sub-beams and/or a proportion of coverage of the array of apertures of one or more plates of the condenser lens array by the sub-beams.

Clause 29. The charged particle-optical module of clause 28, wherein the charged-particle-optical lens is disposed between the beam limiter and the condenser lens array.

Clause 30. A charged particle-optical device for projecting a plurality of sub-beams of charged particles towards a sample, the apparatus comprising the module of any of the preceding clauses.

Clause 31. The charged particle optical device of clause 30, further comprising a power source, desirably a voltage source, for connecting to one or more of the source, the condenser lens array and the macro-corrector system, such as one or more correctors of the macro-corrector system.

Clause 32. The charged particle optical device of claim 30 or 31, further comprising at least one of: an objective lens array; a collimator array positioned at an intermediate focus of the condenser lens array; and a detector array, desirably comprised within and/or providing a sample facing surface of the objective lens array.

Clause 33. A method of using a charged-particle apparatus to generate a plurality of sub-beams from a source beam of charged particles and direct the sub-beams downbeam toward a sample position, the method comprising: emitting a source beam of charged particles along a divergent path; forming a grid of sub-beams from the source beam at an array of apertures defined by a beam limiter; operating on the sub-beams using a condenser lens array, the condenser lens array comprising at least two plates in which are each defined an array of apertures corresponding to the sub-beams and which operate on the beam; and acting on the sub-beams using a macro-corrector system, at least part of the macro-corrector system being between the beam limiter and the condenser lens array.

Clause 34. A charged particle-optical module for generating a plurality of sub-beams from a source beam of electrons, the module for use in an charged particle-optical device for projecting a plurality of sub-beams toward a sample, the charged particle module comprising: an electron source comprising an emitter configured to emit a source beam along a divergent path; and a condenser arrangement comprising multiple plates in which a plurality of apertures are defined, the multiple plates comprising: at least an up beam plate (or top plate) and a down beam (or lower plate); and at least two of the multiple plates comprising a condenser lens array that comprises the down beam plate; the up beam plate configured to be positioned up beam of the down beam plate (or lower plate) in a divergent path of the source beam; the up beam plate being a beam limiter configured to be positioned in the divergent path of the source beam to form sub-beams from the source beam; the condenser lens array configured to operate on the sub-beams and the apertures in the plates of the condenser array are configured to be positioned for passage of the sub-beams; and a macro-corrector system configured to act on the sub-beams, wherein the macro-corrector system compromises a corrector between up beam plate and the down beam plate (or lower plate).

Clause 35. The charged particle-optical module of clause 33, wherein the condenser lens arrangement wherein the up beam plate is the beam limiter and is different plate from any plate comprised within the condenser lens array.

Clause 36. The charged particle-optical module of clauses 34 or 35, wherein the condenser lens array comprising at least the down beam plate and a further plate.

Clause 37. The charged particle-optical module of any of clauses 34 to 36, wherein the condenser lens arrangement comprises a component, such as a corrector, of the macro-corrector system that is positioned between the upbeam plate and the down beam plate (or lower plate).

The terms "sub-beam" and "beamlet" are used interchangeably herein and are both understood to encompass any radiation beam derived from a parent radiation beam by dividing or splitting the parent radiation beam. The term "manipulator" is used to encompass any element or component which operates on a beam of electrons. Such an element or component may affect the path of a sub-beam or beamlet, such as a corrector (e.g. stigmator) lens or deflector.

References to up and low, upper and lower, lowest, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. References to up beam, down beam and beam path are intended to refer to referenced features as designed to operate on a beam of electrons and are intended to refer to such features and their relative position and orientation when the beam is non-operational; so a beam does not need to be present.

References to components (or elements of an array) being aligned along a beam path or sub-beam path are understood to mean that the respective components (or elements) are positioned along the beam path or sub-beam path.

Reference to a component or system of components or elements being controllable to manipulate or operate on a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the electron source 201, control lens array 250, the objective lens array 234, the condenser lens 231, macro-corrector system 60, and scan deflector array 260, under the control of the controller or control system or control unit. An actuatable component, such as a stage, may be controllable to actuate and thus move relative to another components such as the beam path using one or more controllers, control systems, or control units to control the actuation of the component.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical component or element (e.g. an array of multiple deflectors or scan deflectors 260) to operate on the charged particle beam in the charged particle beam path. Additionally or alternatively, in an embodiment the controller 50 controls at least one charged particle-optical element (e.g. the detector 240) to operate on the charged particle beam emitted from the sample 208 in response to the charged particle beam.

Any component, element or collection of elements (such as an array of elements) may be replaceable or field replaceable within the electron optical apparatus 40. The one or more charged particle-optical components in the electron optical apparatus 40, especially those that operate on sub-beams or generate sub-beams, such as aperture arrays and manipulator arrays may comprise one or more MEMS components (or elements) for example a MEMS stack. Reference to a component with the term MEMS is intended to refer to the manufacturing methods and techniques used to manufacture of the such a component, not necessarily the operation of such a component.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses provided herein.

## Claims

1. A charged particle-optical module for generating a plurality of sub-beams from a source beam of electrons, the module for use in an charged particle-optical device for projecting a plurality of sub-beams toward a sample, the charged particle module comprising:
an electron source comprising an emitter configured to emit a source beam along a divergent path;
a beam limiter defining an array of apertures and positioned in the divergent path, wherein the array of apertures are configured to form a grid of sub-beams from the source beam along the divergent path;
a condenser lens array configured to operate on the sub-beams, the condenser lens array comprising at least two plates in which are each defined an array of apertures corresponding to the sub-beams and which are configured to operate on the sub-beams; and
a macro-corrector system configured to act on the sub-beams, wherein the macro-corrector system is at least partly comprised between the beam limiter and the condenser lens array.

2. The charged particle-optical module of claim 1, wherein the macro-corrector system comprises a multipole.

3. The charged particle-optical module of claim 2, wherein the multipole is configured to operate on the sub-beams to vary the positions and/or angular directions of the divergent path of the grid of sub-beams at the condenser lens array.

4. The charged particle-optical module of either of claim 2 or claim 3, wherein the multipole is configured to operate on the sub-beams to vary a cross-sectional shape of the divergent path of the grid of sub-beams at the condenser lens array.

5. The charged particle-optical module of any of claims 2 to 4, wherein the multipole is a first multipole and the macro-corrector system comprises a second multipole, the two multipoles positioned relative to each other between electron source and the condenser lens array.

6. The charged particle-optical module of claim 5, wherein the two multipoles are configured to operate as a lens,.

7. The charged particle-optical module of claim 6, wherein the two multipoles are configured to compensate for variations in distance between the emitter and the condenser lens array.

8. The charged particle-optical module of any of claims 1 to 5, wherein the or at least one plates is mechanically adjustable at least laterally across the path of the grid of sub-beams, for example to position the apertures and the paths of the sub-beams relative to each other,

9. The charged particle optical module of any of claims 2 to 8, wherein the or any or all of the multipoles comprise a plurality of electrodes around an aperture, , the multipoles comprising a number of electrodes that is a factor of four or six or ten.

10. The charged particle optical module of any preceding claim, wherein the macro-corrector system is configured to have a lensing function.

11. The charged particle optical module of any preceding claim, wherein the macro-corrector system comprises a macro lens component.

12. The charged particle-optical module of any preceding claim, wherein the macro-corrector system is configured to operate on the sub-beams to compensate for: misalignment between the apertures of different plates of the beam limiter and the condenser lens array that operate on the same sub-beam and/or variations in dimensional tolerances of the apertures.

13. The charged particle-optical module of any preceding claim, wherein the apertures defined in an uppermost plate of the at least two plates of the condenser lens array have a larger dimension than a corresponding dimension of apertures defined in the beam limiter.

14. The charged particle-optical module of any preceding claim, wherein the macro-corrector system is configured to have the function of a lens, stigmator and/or deflector.

15. A method of using a charged-particle apparatus to generate a plurality of sub-beams from a source beam of charged particles and direct the sub-beams downbeam toward a sample position, the method comprising:
emitting a source beam of charged particles along a divergent path;
forming a grid of sub-beams from the source beam at an array of apertures defined by a beam limiter;
operating on the sub-beams using a condenser lens array, the condenser lens array comprising at least two plates in which are each defined an array of apertures corresponding to the sub-beams and which operate on the beam; and
acting on the sub-beams using a macro-corrector system, at least part of the macro-corrector system being between the beam limiter and the condenser lens array.
